# EUROPEAN PATENT SPECIFICATION

(11) **EP 1 888 455 B1**
(45) Date of publication and mention of the grant of the patent: **27.10.2010**
(21) Application number: 06726950.6
(22) Date of filing: 28.04.2006
(51) Int. Cl.: B82B 3/00, G03F 7/20, G03F 1/00

(54) **A METHOD FOR CREATING AN ARTICLE USING A PIN OF A MICROARRAY SPOTTER**
VERFAHREN ZUR SCHAFFUNG EINES ARTIKELS MIT EINER NADEL EINES MIKROARRAYSPOTTERS
PROCÉDÉ DE CRÉATION D'UN ARTICLE À L'AIDE D'UNE POINTE D'UN ROBOT SPOTTEUR DES MICRO-RÉSÉAUX

(30) Priority: 04.05.2005 GB 0509213
(43) Date of publication of application: 20.02.2008
(73) Proprietor: Surface Innovations Limited, Wolsingham, County Durham DL13 3HH (GB)
(72) Inventor: BADYAL, Jas Pal Singh, County Durham DL13 3HH (GB); MCGETTRICK, James, c/o University of Durham,, Durham DH1 3UP (GB); HARRIS, L. G., Durham City DH1 3HP (GB)
(74) Representative: Greaves, Carol Pauline
(86) International application number: PCT/GB2006/001570
(87) International publication number: WO 2006/117527

(56) References cited:
- JP-A- 59 016 779
- NYFFENEGGER R M & PENNER R M: "Nanometer-Scale Surface Modification Using the Scanning Probe Microscope: Progress since 1991" CHEM REV, vol. 97, 1997, pages 1195-1230, XP002404549
- KRAMER STEPHAN ET AL: "Scanning probe lithography using self-assembled monolayers" CHEM REV, vol. 103, no. 11, November 2003 (2003-11), pages 4367-4418, XP002404550
- ZHANG L B ET AL: "The advancement of SPM-based nanolithography" MATER SCI FORUM, vol. 471-472, 2004, pages 353-357, XP008070443
- ISHIBASHI M ET AL: "FABRICATION OF HIGH-RESOLUTION AND HIGH-ASPECT-RATIO PATTERNS ON A STEPPED SUBSTRATE BY USING SCANNING PROBE LITHOGRAPHY WITH A MULTILAYER-RESIST SYSTEM" JAP J APPL PHYS, vol. 38, no. 4B, April 1999 (1999-04), pages 2445-2447, XP000923642 ISSN: 0021-4922
- BOUCHIAT V & ESTEVE D: "Lift-off lithography using an atomic force microscope" APPL PHYS LETT, vol. 69, no. 20, 11 November 1996 (1996-11-11), pages 3098-3100, XP012016606 ISSN: 0003-6951
- LI MINGTAO ET AL: "Direct three-dimensional patterning using nanoimprint lithography" APPLIED PHYSICS LETTERS, AIP, AMERICAN INSTITUTE OF PHYSICS, MELVILLE, NY, US, vol. 78, no. 21, 21 May 2001 (2001-05-21), pages 3322-3324, XP012028118 ISSN: 0003-6951
- TE-HUA FANG ET AL: "Machining characterization of the nano-lithography process using atomic force microscopy" NANOTECHNOLOGY, vol. 11, no. 3, 1 September 2000 (2000-09-01), pages 181-187, XP020066696 ISSN: 0957-4484
- GLOKLER J ET AL: "Protein and antibody microarray technology" J CHROMATOGRAPHY B, vol. 797, no. 1-2, 25 November 2003 (2003-11-25), pages 229-240, XP004473043 ISSN: 1570-0232
- CHOU S Y ET AL: "Imprint of sub-25 nm vias and trenches in polymers" APPL PHYS LETT, vol. 67, no. 21, 1995, pages 3114-3116, XP012014097

## Description

The invention relates to a method for creating an article including a substrate with at least one surface that is patterned with a chemical functionality with at least one portion of said surface having a different chemical and/or physical property which differs to that of the remainder of said surface.

The chemical patterning of solid surfaces is of crucial importance within many technological fields, including genomic / proteomic array manufacture, microelectronics, sensors, and microfluidics. Methods currently employed to pattern surfaces include: photolithography, laser ablation, surface embossing, block co-polymer segregation, and soft-lithography. Many of these techniques have inherent restrictions, most often the need for highly planar, chemically specific substrates, the employment of expensive lasers and prefabricated masks, and the environmentally unsound use of solvents and corrosive agents.

A general means of producing accurate patterns of any chemical functionality, upon any surface or article, without recourse or limitation to specific chemistries and solvents, is hence a useful and innovative addition to the art.

The preferred use of plasma techniques, to generate at least one of the utilised coatings or surfaces, renders the method of even greater and more wide-spread utility. Plasma techniques are recognised as being a clean, dry, energy and materials efficient alternative to standard wet chemical methods for producing surfaces bearing tailored functionalities.

Plasmas have been successfully employed within previous methods for patterning surfaces. Plasma polymer deposition through a mask has been used to pattern carbon nanotubes (Chen et al, AppL Phys. Lett. 2000, 76, 2719), conducting polymers (Dai et al, J. Phys. Chem. B, 1997, 101, 9548), and cells (France et al, Chem. Mater. 1998, 10, 1176). However, these techniques are restricted to flat, planar substrates (e.g. silica or glass) in order to maintain the prerequisite close physical contact with the mask and ensure adequately high-definition reproduction of its features.

Alternative approaches that can utilise aspects of plasma patterning include nano-sphere lithograph, and the application of photolithography techniques. In the case of nanosphere lithography, it is difficult to extend the pattern over large areas, whereas photolithography critically depends upon the application of photo-resists and the vulnerability of the substrate towards radiation damage.

Scanning probe-based lithography, i.e. mechanical scratching with scanning tunneling microscope tips, atomic force microscope tips or scanning probe microscopy tips has also been employed for patterning surfaces (Nyffenegger & Penner, Chem. Rev. 1997, 97, 1195; Krämer et al, Chem. Rev. 2003, 103, 4367). Furthermore, imprint technology using molds has been used for patterning surfaces (Chou et al, Appl. Phys. Lett. 1995, 67(21), 3114).

According to this invention there is provided a method for the fabrication of a chemically and/or physically patterned surface on a substrate, said method including the provision of at least one surface or homogeneous sub-layer of a desired chemical functionality and wherein a chemically distinct material is applied to form a further or top layer which presents a physical and chemical barrier to the at least one sublayer or surface and the pattern is created by selectively removing at least part of the said further or top layer by puncturing using a pin of a microarraying device to reveal the underlying chemical functionality(s) of the at least one surface or homogenous sub-layer which is spatially restricted to the desired pattern by the surrounding extant top layer.

In one embodiment the at least one sublayer is formed by means including the deposition of at least one material to form the layer and/or by modifying the surface of the substrate to form the layer.

There is therefore provided in one embodiment a method for the fabrication of high-definition chemically and physically patterned surfaces on non-planar substrates. Said method typically initially comprises the generation of a homogeneous layer(s) of desired chemical functionality(s), by means that include the deposition of a coating(s) bearing said functionality(s), or by otherwise appropriately modifying the surface of the substrate. The chemically distinct top-layer can then be applied which presents a physical and chemical barrier to the interaction of the sub-layer(s) with the environment. The pattern is created by selectively removing at least part of the top layer by puncturing using a pin of a micro arraying device to reveal the underlying functionality(s), spatially restricted to the desired pattern by the surrounding extant top layer. The active sub-layer(s) may then be utilized by any means as are known in the art.

In one embodiment a series of sublayers or coatings may be successively applied to the substrate before the application of the top or further layer i.e. that the cited functionalised under-layer itself comprises a manifold of layers. Abrasion of the resultant multi-layer stack to varying depths would then permit the formation of a variety of features displaying different, possibly multiple, functionalities. Suitable means for achieving the required variable depth of abrasion / coating removal are a robotic microarray spotter equipped with a series of pins of differing lengths .

Chemically functionalised layers that may be patterned with great subsequent utility include a range of chemically reactive polymers that may either be reacted / derivatized further or possess inherently useful properties (including, but not restricted to, hydrophobicity, bio-activity, protein attachment, protein resistance, cell adhesion and DNA binding).

A specific example of such a functionalised polymer is poly(glycidyl methacrylate) which has the ability to covalently bind nucleophiles such as amines. A surface bearing a pattern of poly(glycidyl methacrylate) hence has great utility in creating spatially addressed arrays of amine terminated bio-molecules, such as derivatized strands of DNA and proteins.

Other polymers that possess great utility when applied in surface patterns include, but are not limited to: aldehyde functionalised polymers, such as poly(3-vinylbenzaldehyde) and poly(10-undecenal), that can be subsequently derivatised with amine functionalised bio-molecules; thiol functionalised polymers, such as poly(allyl mercaptan), that can be subsequently derivatised with thiol terminated moieties (via disulphide bridge chemistry); pyridine functionalised polymers, such as poly(4-vinyl pyridine), that are both superhydrophilic and can be subsequently derivatized or quarternized with species that include haloalkanes; and halogen functionalised polymers, such as poly(2-bromoethylacrylate) and poly(4-vinylbenzyl chloride), that can be used as initiating sites for grafting procedures (for example, Atom Transfer Radical Polymerisation).

In alternative embodiments of the invention, the patterned functionalised layer may be non-polymeric in nature. Suitable examples include metals, semi-conductors, non-metallic elements, ceramics, and other inorganic surfaces such as silicon nitride and titanium dioxide. Silicon dioxide surfaces are particularly useful because of their amenability to coupling reactions with a huge range of readily available alkoxysilane and chlorosilane reagents.

The functional surfaces listed above are intended to be illustrative rather than limiting. It should be evident to anyone versed in the art that a huge range of functional groups exist that may prove beneficial if patterned according to the method of the invention. In fact, any functionalities that confer contrasting properties to those of the top-layer they are partuered with may be suitable for use in the invention. Examples of properties that may grant value to a substrate when exposed in a pattern include, but are not restricted to, hydrophobicity, hydrophilicity, specific chemical reactivity, chemical sensing ability, wear resistance, gas barrier, filtration, anti-reflective behaviour, controlled release, liquid or stain resistance, enhanced lubricity, adhesion, protein resistance, biocompatibility, bio-activity, the encouragement of cell growth, and the ability to selectively bind biomolecules.

The top-layer that is applied over the functional surface should present a barrier to any interactions of its under-layer(s) with the environment over the timescale of its intended use. In addition, said top layer should be soft enough to facilitate removal by means of puncturing), thus revealing the functionalised under-layer in the desired pattern. Particularly suitable layers for this purpose are thin polymeric, metallic, or inorganic coatings that are substantially inert and insoluble with respect to both their functionalised under-layer and any subsequent procedures (e.g. chemical derivatisation).

In one embodiment of the invention the top-layer is a polymeric in nature. In a particularly preferred embodiment of the invention, the top-layer is a thin pulsed plasma polymer film. In a further preferred embodiment of the invention, the top-layer is a thin, pulsed plasma polymerised film of polystyrene.

The optimum thickness of said top-layer utilised in the method of the invention depends upon a number of factors. These include the barrier characteristics of the top-layer material with respect to any external environments it may experience, the properties of the underlying functional surface and their effective range, the substrate characteristics (e.g. composition, degree of planarity, roughness), and the means of top-layer removal to be employed (e.g. puncturing with the pin of a micro-arrayer).

The most fundamental concern is that the top-layer is sufficiently thick to prevent any significant interaction of the underlying functional surface with the environment. Thus creating a contrast between areas where the top-layer has been removed, and surrounding areas of functionality shielded by extant top-layer.

In embodiments of the invention where the patterned functionality interacts by virtue of direct contact with its environment, the top-layer may be very thin. For example, if the functionalised under-layer comprises a reactive polymer, such as poly(glycidyl methacrylate), that, after patterning, is to be used to directly bind bio-molecules (such as amine-terminated strands of DNA), the shielding top-layer only requires sufficient durability to present a chemical and diffusional obstacle to solution-phase DNA binding chemistry. These barrier conditions may be met by a thin film of any substantially inert and insoluble material, e.g. polystyrene, less than 1000 nm thick, and most preferably less than 200 nm thick.

A variety of means may be used to generate the layers used in the method of the invention. The initial, functionality-bearing layer(s), may be created by applying a coating (or coatings) to a substrate, by chemically modifying a pre-existing surface (e.g. by wet chemical modification or by using a plasma surface treatment, or it may comprise the innate surface functionality of the substrate (for example, the reactive silanol functionality inherent to silica surfaces renders them well suited to patterning without further modification).

Where the creation of a layer used in the method of the invention is achieved by the application of a coating, any means that is known in the art may be utilised. Suitable methods include, but are not limited to: wet chemical deposition, plasma deposition, chemical vapour deposition, electroless deposition, photochemical deposition, spin-coating, solvent casting, spraying, polymerization, graft polymerization, electron beam deposition, and ion bean deposition.

The top-layer (which acts as a barrier and is later selectively removed) may be deposited on top of the initial, functionality-bearing layer by any means as are known in the art (including, but not limited to, spin-coating, solvent casting, spraying, chemical vapour deposition, and plasma methods). The only limitation is that the means of generating the top-layer should not damage or otherwise compromise the utility of the functional layer(s) underneath (except by presenting a physically removable barrier to its interaction with the environment).

In a specific embodiment of the method, the functionality-bearing layer(s) are deposited onto the substrate by means of non-equilibrium plasmas operating at either low pressure, sub-atmospheric pressures, or atmospheric pressure.

In another specific embodiment of the method, the top-layer (which acts as a barrier and is later selectively removed) is a coating deposited onto the functionality-bearing layer by means of a non-equilibrium plasma operating at either low pressure, sub-atmospheric pressures, or atmospheric pressure.

Hence, in preferred embodiments of the invention, either or both of the layers (the under-layer that bears the functionality to be patterned, and the barrier top-layer) are coatings deposited by means of non-equilibrium plasmas.

In further preferred embodiments of the invention the plasma deposited coatings are deposited by means of pulsed plasma polymerisation techniques.

A variety of procedures may be used to selectively remove the top-layer from the functionalised under-layer. Said means are preferably physical in nature and rely upon tribological abrasion to remove the barrier layer and expose the functional layer in the desired spatial pattern. Especially favoured techniques are those that permit the preparation of micron and nano scale features. Such patterns are the most difficult to prepare by alternative means and permit the preparation of a variety of devices, including but not limited to: high throughput gnomic / proteomic microelectronics, sensors and microfluidics.

In the present invention, the pin of a microarrayer is used to puncture the top-layer and expose the reactive under-layer. Microarraying devices (such as those manufactured by Genetix Limited. Hampshire, United Kingdom) are normally used to generate protein / DNA arrays, utilising a pin to transfer small droplets of protein / DNA solution from storage wells, onto a reactive surface at spatially addressed sites ("spotting"). In a preferred embodiment of the method of the invention, the spotting pin of a said microarraying device is configured so that it penetrates the top-layer, exposing the functional surface underneath. The size and shape of the features created by this technique are a function of the cross-sectional area of the pin, typically 1-200 µm. This top-layer removal step may evidently be accompanied by the simultaneous delivery of a droplet of liquid, enabling the concomitant patterning and derivatization of a surface. The utilisation in the method of a top-layer that acts as a barrier to any droplet interaction with the functional layer outside of the pin diameter, enables spotting at far higher resolutions than is possible using existing micro arraying techniques.

In further preferred embodiment of the method, where the top-layer is applied over a multilayered stack of functional coatings, it is required that the means of coating removal can be applied to differing depths. The application of said means of removal permits the formation of features displaying different combinations of exposed functionality on the same substrate. Apparatuses capable or delivering the necessary variable depth of abrasion / coating removal include robotic microarray spotters equipped with a multitude of pins of differing lengths.

However, of special utility are those means of top-layer removal capable of creating patterns and features at scales sufficiently small to enable the production of biological microarrays. For said purpose, features of less than 100 µm are especially desirous.

An article can be provided in the form of a substrate having at least one surface or sub-layer with a first chemical functionality and a top layer applied thereover having a differing chemical functionality wherein part of said top layer is selectively removed by puncturing using a pin of a microarray device to form a desired pattern to expose the chemical functionality of the material of said surface and/or sub-layer restricted to the desired pattern.

In a preferred embodiment at least one sublayer is applied to the substrate, with said top layer applied thereover. In one embodiment a plurality of sublayers are applied and the top layer and selected sub-layer(s) are removed to selectively expose the material of the selected sub-layers at predefined parts of the substrate.

Typically parts of the material of the top layer are removed to form a preferred pattern of exposed areas of the sub-layer and/or surface.

The top layer typically acts as a barrier to exposure of the covered surface and/or sub-layer to the external environment.

In preferred embodiments of the invention either or both of the layers (the under-layer that bears the functionality to be patterned, and the barrier top-layer) are plasma polymers. Plasma polymers are typically generated by subjecting a coating-forming precursor to an ionising electric field under low-pressure conditions. Although atmospheric-pressure and sub-atmospheric pressure plasmas (including atomised spray devices) are known and utilised for this purpose in the art Deposition occurs when excited species generated by the action of the electric field upon the precursor (radicals, ions, excited molecules etc.) polymerise in the gas phase and react with the substrate surface to form a growing polymer film.

However, it has been noted that the utility of plasma deposited coatings is often compromised by excessive fragmentation of the coating forming precursor during plasma processing. This problem has been addressed in the art by pulsing the applied electrical field in a sequence that yields a very low average power thus limiting monomer fragmentation and increasing the resemblance of the coating to its precursor (i.e. improving "monomer retention"). Examples of such sequences include those in which the plasma is on for 20 µs and off for from 1000 µs to 20000 µs. International Patent Application number WO9858117 (The Secretary of State for Defence, GB) describes such a process in which oil repellent coatings are produced by the pulsed plasma polymerisation of perfluorinated acrylate monomers.

Precise conditions under which pulsed plasma deposition of the coating(s) utilised in the method of the invention takes place in an effective manner will vary depending upon factors such as the nature of the monomer(s), the substrate, the size and architecture of the plasma deposition chamber etc. and will be determined using routine methods and/or the techniques illustrated hereinafter. In general however, polymerisation is suitably effected using vapours or atomised droplets of the monomers at pressures from 0.01 to 1000 mbar. The most suitable plasmas are those that operate at low pressures i.e. less than 10 mbar, particularly at approximately 0.2 mbar. Although atmospheric-pressure (greater than or equal to 1000 mbar) and sub-atmospheric pressure (10 to 1000 mbar) plasmas are known and utilised for plasma polymer deposition in the art

A glow discharge is then ignited by applying a high frequency voltage, for example at 13.56 MHz. The applied fields are suitably of an average power of up to 50 W.

The fields are suitably applied for a period sufficient to give the desired coating. In general, this will be from 30 seconds to 60 minutes, preferably from 1 to 15 minutes, depending upon the nature of the monomer(s), the substrate and the intended purpose of the plasma polymer film (i.e. functional coating or barrier top-layer) etc.

Suitably, the average power of the pulsed plasma discharge is low, for example of less than 0.05 W/cm³, preferably less than 0.025 W/cm³ and most preferably less than 0.0025 W/cm³.

The pulsing regime which will deliver such low average power discharges will vary depending upon the nature of the substrate, the size and nature of the discharge chamber etc. However, suitable pulsing arrangements can be determined by routine methods in any particular case. A typical sequence is one in which the power is on for from 10 µs to 100 µs, and off for from 1000 µs to 20000 µs.

Suitable plasmas for use in the method of the invention include non-equilibrium plasmas such as those generated by audio-frequencies, radiofrequencies (RF) or microwave frequencies. In another embodiment the plasma is generated by a hollow cathode device. In yet another embodiment, the pulsed plasma is produced by direct current (DC).

The plasma(s) may operate at low, sub-atmospheric or atmospheric pressures as are known in the art. The monomer(s) may be introduced into the plasma as a vapour or an atomised spray of liquid droplets (WO03101621 and WO03097245, Surface Innovations Limited). The monomer(s) may also be introduced into the pulsed plasma deposition apparatus continuously or in a pulsed manner by way of, for example, a gas pulsing valve

The substrate to which the coating(s) are applied will preferentially be located substantially inside the pulsed plasma during coating deposition. However, the substrate may alternatively be located outside of the pulsed plasma, thus avoiding excessive damage to the substrate or growing coating.

The monomer(s) will typically be directly excited within the plasma discharge. However, "remote" plasma deposition methods may be used as are known in the art. In said methods the monomer enters the deposition apparatus substantially "downstream" of the pulsed plasma, thus reducing the potentially harmful effects of bombardment by short-lived, high-energy species such as ions.

In alternative embodiments of the invention, materials additional to the plasma polymer coating precursor(s) are present within the plasma deposition apparatus. The additional materials may be introduced into the coating deposition apparatus continuously or in a pulsed manner by way of, for example, a gas pulsing valve.

Said additive materials may be inert and act as buffers without any of their atomic structure being incorporated into the growing plasma polymer (suitable examples include the noble gases). A buffer of this type may be necessary to maintain a required process pressure. Alternatively the inert buffer may be required to sustain the plasma discharge. For example, the operation of atmospheric pressure glow discharge (APGD) plasmas often requires large quantities of helium. This helium diluent maintains the plasma by means of a Penning Ionisation mechanism without becoming incorporated within the deposited coating.

In other embodiments of the invention, the additive materials possess the capability to modify and/or be incorporated into the coating forming material and/or the resultant plasma deposited coating. Suitable examples include other reactive gases such as halogens, oxygen, and ammonia.

In one embodiment the portions are removed so as to form a spatial pattern of said portions with said chemical functionality(s).

In one embodiment the exposed portions are subsequently modified by means of any chemical or biological reaction or interaction.

In one embodiment plasma deposition is used to generate either, or both, the desired functional surface and/or said layer.

The invention will now be particularly described by way of examples with reference to the accompanying drawings in which:

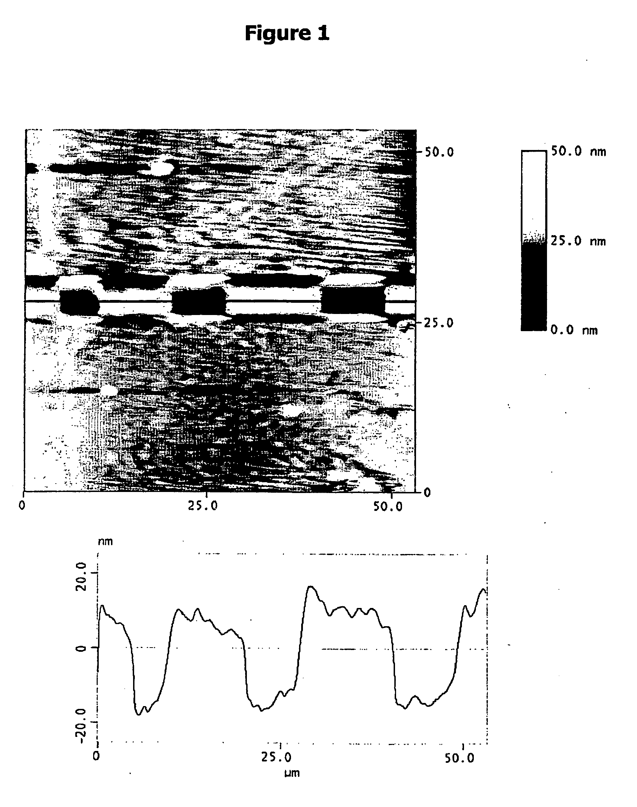

Figure 1 shows a topographic AFM image and cross-sectional analysis not forming part of the present invention of a patterned pulsed plasma polymer bi-layer deposited on a silicon substrate, comprising 20 nm of polystyrene on top of a 1500 nm thick coating of poly(glycidyl methacrylate), selectively abraded with the AFM probe tip before imaging.

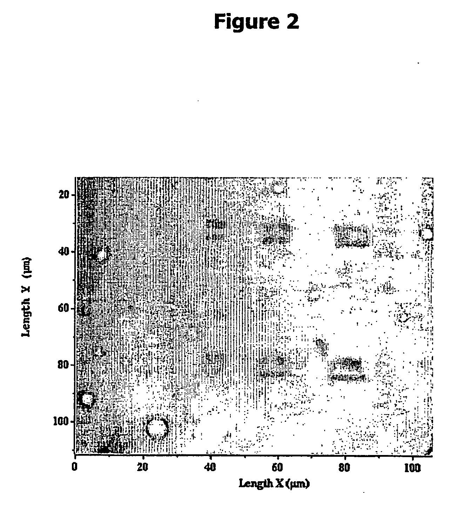

Figure 2 shows an optical image of a patterned pulsed plasma polymer bi-layer deposited on a silicon substrate, comprising 20 nm of polystyrene on top of a 1500
   nm thick coating of poly(glycidyl methacrylate), selectively abraded with the AFM probe tip not forming part of the present invention before imaging.

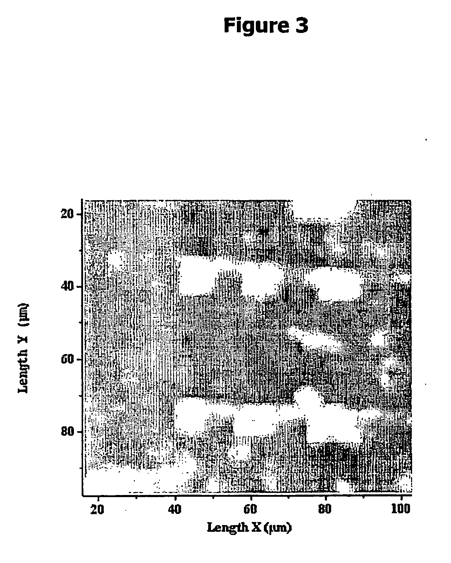

Figure 3 shows a fluorescence map of a patterned pulsed plasma polymer bi-layer deposited on a silicon substrate, comprising 20 nm of polystyrene on top of a 1500 nm thick coating of poly(glycidyl methacrylate), selectively abraded with the AFM probe tip and subsequently derivatized with an amine functionalized dye (cresyl violet perchlorate) before imaging.

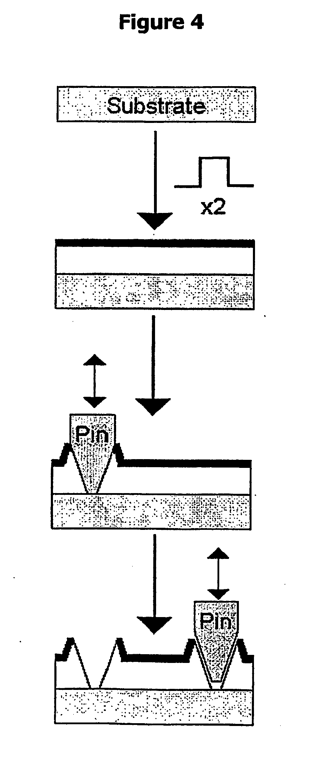

Figure 4 is a scheme showing the manufacture of micro-well arrays. The substrate is first treated with a reactive plasma polymer (white layer), which is then masked with a second, inert plasma polymer (the thin, dark layer). The pin of a robotic microarray spotter is then used to repeatedly puncture the surface according to the present invention, producing an array of micro-wells containing exposed, reactive plasma polymer.

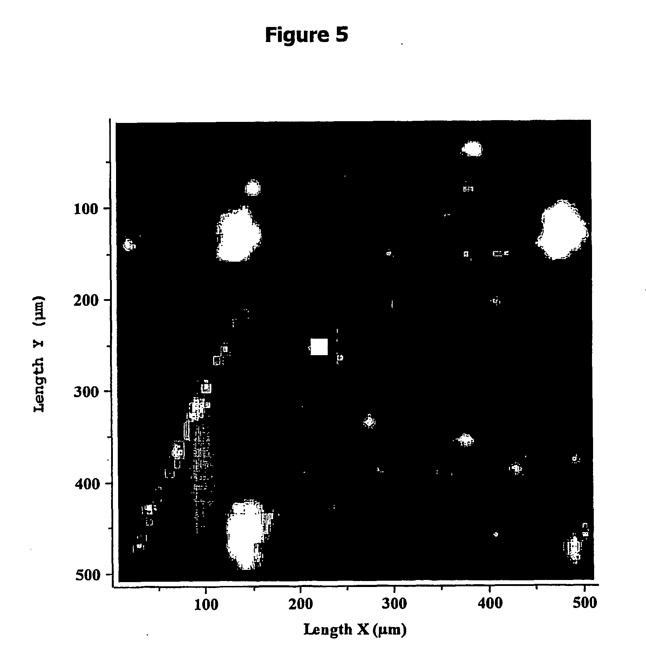

Figure 5 shows a fluorescence microscopy image of a Cy5-tagged oligonucleotide derivatized micro-well array manufactured on a bi-layer of poly(3-vinylbenzaldehyde) and polystyrene plasma polymers. The size and pitch of the bright regions corresponds to the impact of the spotting tip, and confirms exposure of the reactive poly(3-vinylbcnzaldehyde) layer.

The following examples are intended to illustrate the present invention but are not intended to limit the same:

### Example 1

Pulsed plasma polymerisation was used to deposit a reactive layer of poly(glycidyl methacrylate) upon a silicon-wafer substrate. The resultant epoxide functionalised surface was then covered with a top-layer of polystyrene, again by pulsed plasma polymerisation. Patterning was achieved by using an Atomic Force Microscope (AFM) probe-tip not forming part of the present invention to scratch away areas of this polystyrene barrier layer. The exposed areas of under-lying poly(glycidyl methacrylate) functionality were then selectively derivatized using an amine functionalised fluorescent dye. The efficacy of patterning was confirmed by fluorescence microscopy.

The pulsed plasma deposition of the initial poly(glycidyl methacrylate) functional layer was performed as follows. Glycidyl methacrylate (Fluka, >97 % purity) plasma polymer precursor was loaded into a resealable glass tube and purified using several freeze-pump-thaw cycles. Pulsed plasma polymerization of the epoxide-functionalised monomer was carried out in a cylindrical glass reactor (4.5 cm diameter, 460 cm³ volume, 2 x 10⁻³ mbar base pressure, 1.4 x 10⁻⁹ mols⁻¹ leak rate) surrounded by a copper coil (4 mm diameter, 10 turns, located 15 cm away from the precursor inlet) and enclosed in a Faraday cage. The chamber was evacuated using a 30 L min⁻¹ rotary pump, attached via a liquid nitrogen cold trap, and the pressure monitored with a Pirani gauge. All fittings were grease-free. During pulsed plasma deposition the radiofrequency power supply (13.56 MHz) was triggered by a square wave signal generator with the resultant pulse shape monitored using an oscilloscope. The output impedance of the RF power supply was matched to the partially ionised gas load using an L-C matching network.

Prior to use, the apparatus was thoroughly cleaned by scrubbing with detergent, rinsing in propan-2-ol, and oven drying. At this stage the reactor was reassembled and evacuated to base pressure. Further cleaning comprised running a continuous wave air plasma at 0.2 mbar and 40 W for 30 minutes. Next, a silicon wafer (10 mm x 15 mm) was inserted into the centre of the reactor and the system re-evacuated to base pressure. Monomer vapour was then introduced into the chamber at a pressure of 0.2 mbar for 5 mm prior to plasma ignition. Optimum epoxide functional group retention at the surface was found to require 40 W continuous wave bursts lasting 20 µs (*tₒₙ*), interspersed by off-periods (*t*_{off}) of 20000 µs. The average power delivered to the system during this pulsing regime was hence 0.04 W. After 60 minutes of deposition, the RF generator was switched off and the precursor allowed to purge through the system for a further 5 minutes. Finally, the chamber was re-evacuated to base pressure and vented to atmosphere.

X-ray photoelectron spectroscopy (XPS), Fourier Transform Infra-red Spectroscopy (FT-IR) and reflectometry confirmed the creation of a 1565 nm thick layer of poly(glycidyl methacrylate) on the silicon wafer.

The subsequent deposition of the polystyrene top-layer was achieved using an analogous pulsed plasma polymerisation procedure to that described above. Styrene monomer (Sigma, >99 % purity, further purified by several freeze-pump-thaw cycles) was polymerized in an identical plasma deposition apparatus, at a vapour pressure of 0.2 mbar, for 5 minutes, using 40 W continuous wave bursts lasting 100 µs (*tₒₙ*), interspersed by off-periods (*t*_{off}) of 4000 µs (the average power was hence 0.98 W).

The presence of a ∼20 nm thick over-layer of polystyrene on top of the epoxide coated silicon wafers was confirmed by XPS, reflectometry, and water contact angle measurements (the water contact angle increased from 64° ±4°, indicative of poly(glycidyl methacrylate), to 86° ±1°, indicative of polystyrene).

Patterning of the plasma deposited poly(glycidyl methacrylate) / polystyrene bi-layer was both executed and observed using an Atomic Force Microscope (Digital Instruments Nanoscope III, equipped with control module, extender electronics and a signal access module). Three areas of the polystyrene top-layer were physically scratched away using a tapping mode tip (Nanoprobe, spring constant 42-83 N/m) applied in contact mode in the selected pattern using a program written in the Veeco Nanolithography Software (Version 5.30r1). Images of the patterned samples were afterwards obtained in contact mode at scan rate of 1 Hz. Topographic and cross-sectional analyses confirmed the creation of three areas (5×s µm, 5×6 µm, and 5×10 µm) where the polystyrene top-layer had been removed to a depth of ∼20 nm, Figure 1.

The success of the AFM-mediated physical patterning approach was shown by the attachment of an amine functionalized dye to the exposed epoxide moieties of the underlying poly(glycidyl methacrylate) film. Dyeing comprised immersing the patterned sample in a 1% w/v aqueous solution of cresyl violet perchlorate (Sigma) for 1 hour before rinsing in distilled water for 24 hours and drying. A fluorescence microscope system (LABRAM, Tobin Yvon Ltd, equipped with a 633 nm He-Ne laser) was used to optically image and fluorescently map the patterned surface, Figure 2 and Figure 3. Fluorescence mapping clearly showed that the attachment of the cresyl violet dye was restricted to the areas of poly(glycidyl methacrylate) exposed within the abraded squares. This confirms that pulsed plasma polymerisation is a suitable methodology for the production of both the functional and barrier layers of the invention, and that an AFM probe tip is an effective, highly controllable means of top-layer removal.

### Example 2

Pulsed plasma polymerisation was used to deposit a reactive layer of poly(3-vinylbenzaldehyde) onto a borosilicate glass coverslip. The resultant aldehyde functionalised coating was then screened with an inert top-layer of polystyrene, again by pulsed plasma polymerisation. Patterning was performed using the pin of a robotic microarray spotter to punch through the polystyrene barrier layer, exposing areas of the underlying poly(3-vinylbenzaldehyde), Figure 4. These aldehyde functionalised microwells were then selectively reacted with a fluorescently tagged, amine-terminated oligonucleotide, using reductive amination chemistry.

Pulsed plasma polymerization was performed using a broadly identical apparatus and procedure to that described in Example 1. Pulsed plasma deposition of the reactive poly(3-vinylbenzaldehyde) layer was performed from 3-vinylbenzaldehyde monomer (Aldrich, 97% purity, further purified by repeated free-pump-thaw cycles) at a vapour pressure of 0.2 mbar, for 5 minutes, using 40 W continuous wave bursts lasting 50 µs (*tₒₙ*), interspersed by off-periods (*t*_{off}) of 4000 µs (the average power was hence 0.49 W). XPS analysis and reflectometry confirmed the deposition of a 200 nm thick film possessing good structural retention of the monomer functionality.

The subsequent deposition of a polystyrene top layer utilized the same plasma parameters described in Example 1. However, a longer deposition duration resulted in a ∼180 nm thick over-layer of polystyrene on top of the aldehyde coated glass coverslip.

The resultant poly(3-vinylbenzaldehyde) / polystyrene bi-layer system was patterned using a robotic microarray spotter, equipped with a stainless steel pin, to puncture holes in the sample surface. This procedure generated an array of micro-wells (print pitch = 350 µm) containing exposed poly(3-vinylbenzaldehyde).

The successful creation of accessible aldehyde functionality was demonstrated by its derivatization with a Cy5-fluorophore tagged oligonucleotide using reductive amination chemistry. This procedure comprised immersion of the patterned sample in a pH 4.5 saline sodium citrate buffer containing the probe nucleotide (Sigma-Genosys, oligonucleotide sequence: 5'-3' AACGATGCACGAGCA, desalted, reverse phase purified with 3' terminal primary amine and 5' terminal Cy5 fluorophore) at 42 °C, for 16 hours. Subsequently 3.5 mg ml⁻¹ NaCN(BH₃) (Aldrich, 99%) was added and the solution gently stirred for a further 3 hours. Excess physisorbed oligonucleotides were then removed by sequential washing in high purity water; saline sodium citrate buffer (SSC, 0.3M Sodium Citrate, 3M NaCl, pH 7, Sigma) with 1% sodium dodecyl sulphate (Sigma, 10% solution); high purity water; solution of 10% stock SSC buffer in high purity water with 0.1% (w/v) sodium dodecyl sulphate; high purity water; 5% stock SSC buffer in high purity water; and finally, high purity water.

The attachment of the fluorescently tagged oligonucleotide to the array of exposed poly(3-vinylbenzaldehyde) sites was verified using a fluorescent microscope (LABRAM, Tobin Yvon Ltd, equipped with a 633 nm Hc-Ne laser). Fluorescence mapping clearly showed that the attachment of the Cy5-tagged oligonucleotide was restricted to the areas of poly(3-vinylbenzaldehyde) exposed on the walls of the micro-wells, and that the polystyrene over-layer acted as a substantially inert barrier to the reductive amination chemistry employed, Figure 5.

This result demonstrates that pulsed plasma polymerisation is a suitable methodology for the production of both the functional and the barrier layers of the invention. In addition, a microarray spotting pin is shown to be an effective means of puncturing the inert top-layer enabling the creation of multiplex arrays of spatially-localised reactive sites.

Thus the present invention illustrates the manner in which a chemically patterned surface can be created by the selective removal of portions of the surface and/or selected depths of the surface coatings so as to allow selected chemically active or inactive and/or particular chemical attributes to be exposed at the surface of the substrate for subsequent use.

## Claims

1. A method for the fabrication of a chemically and/or physically patterned surface on a substrate, said method including the provision of at least one surface or homogeneous sublayer of a desired chemical functionality and wherein a chemically distinct material is applied to form a further or top layer which presents a physical and chemical barrier to the at least one sublayer or surface and the pattern is created by selectively removing at least part of the said further or top layer by puncturing using a pin of a microarraying device to reveal the underlying chemical functionality(s) of the at least one surface or homogenous sub-layer which is spatially restricted to the desired pattern by the surrounding extant top layer.

2. A method according to claim 1 wherein the at least one sublayer is formed by means including the deposition of at least one material to form the sub-layer and/or by modifying the surface of the substrate.

3. A method according to claim 1 wherein the at least one sub-layer material is utilized in the areas where the same has been exposed to the external environment.

4. A method according to claim 1 wherein a series of sub-layer coatings are successively applied to the substrate before the application of the top layer.

5. A method according to claim 4 wherein abrasion of the resultant multi-layer stack is performed to varying depths at selected areas to permit the formation of a variety of features displaying different, possibly multiple, functionalities at specified areas of the substrate surface.

6. A method according to claim 5 wherein a robotic microarray spotter equipped with a series of pins of differing lengths, is used to selectively remove material to the required depth.

7. A method according to claim 1 wherein the at least one sub-layer which is formed includes any of a range of chemically reactive polymers that can be reacted/derivatized further.

8. A method according to claim 7 wherein the polymers include the properties of any, or any sub-section, of hydrophobicity, bio-activity, protein attachment, protein resistance, cell adhesion and/or DNA binding.

9. A method according to claim 7 wherein the polymer is poly(glycidyl methacrylate).

10. A method according to claim 9 wherein a substrate surface is created having a pattern of exposed poly(glycidyl methacrylare) on the surface creating spatially addressed arrays of amine terminated bio-molecules.

11. A method according to claim 10 wherein derivatized strands of DNA and proteins are created in the exposed areas of the substrate surface.

12. A method according to claim 7 wherein polymers used are any or any combination of aldehyde functionalised polymers that can be subsequently derivatised with amine functionalised bio-molecules; thiol functionalised polymers that can be subsequently dcrivatiscd with thiol terminated moieties, pyridine functionalised polymers that are superhydrophilic and can be subsequently derivatised or quarternized with species that include haloalkanes and/or halogen functionalised polymers that can be used as initiating sites for grafting procedures.

13. A method according to claim 1 wherein the at least one sub-layer is formed to be non-polymeric in nature.

14. A method according to claim 13 wherein materials to form the sub layer used include any or any combination of metals, semi-conductors, non-metallic elements, ceramics, and/or inorganic surfaces such as silicon nitride and titanium dioxide.

15. A method according to claim 1 wherein a material with a functionality that confers contrasting properties to those of a material used to form the top-layer is applied to form the at least one sub-layer.

16. A method according to claim 15 wherein properties that can be considered when the sublayer is exposed in a pattern include any or any combination of hydrophobicity, hydrophilicity, specific chemical reactivity, chemical sensing ability, wear resistance, gas barrier, filtration, anti-reflective behaviour, controlled release, liquid or stain resistance, enhanced lubricity, adhesion, protein resistance, biocompatibility, bio-activity, the encouragement of cell growth, and/or the ability to selectively bind biomolecules.

17. A method according to claim 1 wherein the top-layer that is applied over the sub layer presents a barrier to any interactions with the covered sub-layer with the surrounding environment over a specified timescale.

18. A method according to claim 1 wherein the top layer is sufficiently soft to facilitate removal by means of puncturing to reveal the functionalised sub-layer in the desired pattern.

19. A method according to claim 1 wherein the top-layer is polymeric in nature.

20. A method according to claim 19 wherein the top-layer is a thin polymer film.

21. A method according to claim 1 wherein the top-layer is applied using a pulsed plasma.

22. A method according to claim 21 wherein the top layer is a thin, polymerised film of polystyrene applied using a pulsed plasma.

23. A method according to claim 1 wherein the top-layer is sufficiently thick to prevent any significant interaction of the covered sub-layer with the environment surrounding the substrate.

24. A method according to claim 1 wherein the at least one sub-layer comprises a reactive polymer to be used, where exposed, to directly bind bio-molecules and the top-layer presents a chemical and diffusional obstacle to solution-phase DNA binding chemistry

25. A method according to claim 1 wherein the at least one sub-layer is deposited onto the substrate by means of a non-equilibrium plasma.

26. A method according to claim 1 wherein the top layer is a coating deposited onto the at least one sub-layer by means of a non-equilibrium plasma.

27. A method according to claim 1 wherein a spotting pin of said micro-arraying device is configured to penetrate the top layer, exposing the functional surface underneath.

28. A method according to claim 27 wherein the step is accompanied by the simultaneous delivery of a droplet of liquid, enabling the concomitant patterning of the surface and derivatization of the exposed sub-layer.

29. A method according to claim 1 wherein at least one sub-layer is removed in addition to the top layer at at least one location to form features displaying different combinations of exposed functionality on the same substrate.

30. A method according to claim 1 wherein either or both of the top and/or sub layers are plasma polymers.

31. A method according to claim 30 wherein the plasma used to apply the plasma polymers is pulsed.

32. A method according to claim 31 wherein a glow discharge is ignited by applying a high frequency voltage, with the applied fields having an average power of up to 5OW.

33. A method according to claim 31 wherein the pulsing sequence for the plasma is that the power is on from between 10 µs to 100 µs, and off from between 1000 µs to 20000 µs.

34. A method according to claim 32 wherein the substrate to which the coating(s) are applied is located substantially inside the pulsed plasma during coating deposition.

35. A method according to claim 32 wherein materials additional to the plasma polymer coating procursor(s) are present at the plasma deposition.

36. A method according to claim 35 wherein said additive materials are inert and act as buffers without any of their atomic structure being incorporated into the growing plasma polymer.

37. A method according to claim 35 wherein the additive material possesses the capability to modify and/or be incorporated into the coating forming material and/or the resultant plasma deposited coating.

## Patentansprüche

1. Verfahren zur Herstellung einer chemisch und/oder physikalisch gemusterten Oberfläche auf einem Substrat, wobei das Verfahren die Bereitstellung von mindestens einer Oberfläche oder homogenen Unterschicht von einer gewünschten chemischen Funktionalität beinhaltet und wobei ein chemisch verschiedenes Material aufgebracht wird, um eine weitere oder obere Schicht zu bilden, die für die mindestens eine Unterschicht oder Oberfläche eine physikalische und chemische Barriere darstellt, und das Muster durch selektives Entfernen mindestens eines Teils der weiteren oder oberen Schicht durch Durchstoßen unter Verwendung einer Nadel einer Microarraying-Vorrichtung erzeugt wird, um die darunter liegende(n) chemische(n) Funktionalität(en) der mindestens einen Oberfläche oder homogenen Unterschicht freizulegen, die durch die umgebende noch vorhandene obere Schicht räumlich auf das gewünschte Muster begrenzt wird.

2. Verfahren nach Anspruch 1, wobei die mindestens eine Unterschicht durch Mittel, welche die Abscheidung von mindestens einem Material beinhalten, um die Unterschicht zu bilden, und/oder durch Modifizieren der Oberfläche des Substrats gebildet wird.

3. Verfahren nach Anspruch 1, wobei das mindestens eine Unterschicht-Material in den Bereichen eingesetzt wird, in denen dieses der äußeren Umgebung ausgesetzt worden ist.

4. Verfahren nach Anspruch 1, wobei vor der Aufbringung der oberen Schicht eine Reihe von Unterschicht-Beschichtungen nacheinander auf das Substrat aufgebracht werden.

5. Verfahren nach Anspruch 4, wobei ein Abtrag des sich ergebenden mehrschichtigen Stapels auf unterschiedliche Tiefen in ausgewählten Bereichen durchgeführt wird, um die Bildung einer Vielfalt von Merkmalen, die unterschiedliche, möglicherweise multiple Funktionalitäten in spezifizierten Bereichen der Substratoberfläche zeigen, zu ermöglichen.

6. Verfahren nach Anspruch 5, wobei ein Microarray-Spotter-Roboter, der mit einer Reihe von Nadeln von unterschiedlichen Längen ausgerüstet ist, verwendet wird, um das Material selektiv bis zur gewünschten Tiefe zu entfernen.

7. Verfahren nach Anspruch 1, wobei die mindestens eine Unterschicht, die gebildet wird, irgendeines von einer Reihe von chemisch reaktiven Polymeren beinhaltet, die weiter umgesetzt/derivatisiert werden können.

8. Verfahren nach Anspruch 7, wobei die Polymere Eigenschaften von irgendwelchen oder irgendwelchen Unterklassen von Hydrophobie, Bioaktivität, Proteinanhaftung, Proteinresistenz, Zelladhäsion und/oder DNA-Bindung beinhalten.

9. Verfahren nach Anspruch 7, wobei das Polymer Poly(glycidylmethacrylat) ist.

10. Verfahren nach Anspruch 9, wobei eine Substratoberfläche erzeugt wird, die ein Muster von freigelegtem Poly(glycidylmethacrylat) auf der Oberfläche aufweist, wobei räumlich adressierte Arrays von Biomolekülen mit Amin-Endgruppe gebildet werden.

11. Verfahren nach Anspruch 10, wobei derivatisierte Stränge von DNA und Proteine in den freigelegten Bereichen der Substratoberfläche gebildet werden.

12. Verfahren nach Anspruch 7, wobei die verwendeten Polymere irgendwelche oder irgendeine Kombination von Aldehyd-funktionalisierten Polymeren, die anschließend mit Amin-funktionalisierten Biomolekülen derivatisiert werden können; Thiol-funktionalisierten Polymeren, die anschließend mit Einheiten mit Thiol-Endgruppe derivatisiert werden können, Pyridin-funktionalisierten Polymeren, die superhydrophil sind und anschließend mit Spezies, die Halogenalkane und/oder Halogen-funktionalisierte Polymere umfassen, derivatisiert oder quaternisiert werden können, die als Initiierungsstellen für Propfverfahren verwendet werden können, sind.

13. Verfahren nach Anspruch 1, wobei die mindestens eine Unterschicht gebildet wird, so dass sie von der Beschaffenheit nicht-polymer ist.

14. Verfahren nach Anspruch 13, wobei eingesetzte Materialien zur Bildung der Unterschicht irgendwelche oder irgendeine Kombination von Metallen, Halbleitern, Nichtmetallelementen, Keramiken und/oder anorganischen Oberflächen wie Siliciumnitrid und Titandioxid beinhalten.

15. Verfahren nach Anspruch 1, wobei ein Material mit einer Funktionalität, die kontrastierende Eigenschaften zu denen von einem Material, das zur Bildung der oberen Schicht verwendet wird, verleiht, aufgebracht wird, um die mindestens eine Unterschicht zu bilden.

16. Verfahren nach Anspruch 15, wobei Eigenschaften, die berücksichtigt werden können, wenn die Unterschicht in einem Muster freigelegt wird, irgendwelche oder irgendeine Kombination von Hydrophobie, Hydrophilie, spezifischer chemischer Reaktivität, chemischem Messvermögen, Abriebbeständigkeit, Gasbarriere, Filtration, Antireflexionsvermögen, kontrollierter Freisetzung, Flüssigkeits- oder Schmutzbeständigkeit, erhöhter Gleitfähigkeit, Adhäsion, Proteinresistenz, Biokompatibilität, Bioaktivität, Förderung des Zellwachstums und/oder der Fähigkeit, Biomoleküle selektiv zu binden, beinhalten.

17. Verfahren nach Anspruch 1, wobei die obere Schicht, die über der Unterschicht aufgebracht ist, eine Barriere für irgendwelche Wechselwirkungen der bedeckten Unterschicht mit der umgebenden Umwelt über eine bestimmte Zeitskala darstellt.

18. Verfahren nach Anspruch 1, wobei die obere Schicht ausreichend weich ist, um die Entfernung mittels Durchstoßen zu erleichtern, um die funktionalisierte Unterschicht im gewünschten Muster freizulegen.

19. Verfahren nach Anspruch 1, wobei die obere Schicht in der Beschaffenheit polymer ist.

20. Verfahren nach Anspruch 19, wobei die obere Schicht ein dünner Polymerfilm ist.

21. Verfahren nach Anspruch 1, wobei die obere Schicht unter Verwendung eines Puls-Plasmas aufgebracht wird.

22. Verfahren nach Anspruch 21, wobei die obere Schicht ein dünner, polymerisierter Film aus Polystyrol ist, der unter Verwendung eines Puls-Plasmas aufgebracht wird.

23. Verfahren nach Anspruch 1, wobei die obere Schicht ausreichend dick ist, um irgendeine signifikante Wechselwirkung der bedeckten Unterschicht mit der Umgebung, die das Substrat umgibt, zu verhindern.

24. Verfahren nach Anspruch 1, wobei die mindestens eine Unterschicht ein reaktives Polymer umfasst, das bei Freilegung zu verwenden ist, um Biomoleküle direkt zu binden, und die obere Schicht ein chemisches und Diffusionshindernis für die DNA-Bindungschemie in Lösung darstellt.

25. Verfahren nach Anspruch 1, wobei die mindestens eine Unterschicht mit Hilfe eines Plasmas im Nichtgleichgewicht auf dem Substrat abgeschieden wird.

26. Verfahren nach Anspruch 1, wobei die obere Schicht eine Beschichtung ist, die mit Hilfe eines Plasmas im Nichtgleichgewicht auf die mindestens eine Unterschicht abgeschieden wird.

27. Verfahren nach Anspruch 1, wobei eine Spotting-Nadel der Microarraying-Vorrichtung so gestaltet ist, dass sie die obere Schicht penetriert, wobei die darunter liegende funktionelle Oberfläche freigelegt wird.

28. Verfahren nach Anspruch 27, worin der Schritt von der gleichzeitigen Anlieferung eines Flüssigkeitströpfchens begleitet wird, was begleitend das Versehen der Oberfläche mit einem Muster und die Derivatisierung der freigelegten Unterschicht ermöglicht.

29. Verfahren nach Anspruch 1, wobei mindestens eine Unterschicht zusätzlich zur oberen Schicht an mindestens einer Stelle entfernt wird, um Eigenschaften zu bilden, die unterschiedliche Kombinationen von freigelegter Funktionalität auf dem gleichen Substrat zeigen.

30. Verfahren nach Anspruch 1, wobei eine oder beide von oberer Schicht und/oder Unterschichten Plasma-Polymere sind.

31. Verfahren nach Anspruch 30, worin das Plasma, das zur Aufbringung der Plasma-Polymere verwendet wird, gepulst ist.

32. Verfahren nach Anspruch 31, wobei eine Glimmentladung durch Anlegen einer Hochfrequenzspannung gezündet wird, wobei die angelegten Felder eine mittlere Leistung von bis zu 50 W aufweisen.

33. Verfahren nach Anspruch 31, worin die Pulssequenz für das Plasma darin besteht, dass die Leistung zwischen 10 µs und 100 µs eingeschaltet ist und zwischen 1000 µs und 20000 µs abgeschaltet ist.

34. Verfahren nach Anspruch 32, wobei das Substrat, auf das die Schicht(en) aufgebracht wird bzw. werden, sich während der Schichtabscheidung im wesentlichen innerhalb des Puls-Plasmas befindet.

35. Verfahren nach Anspruch 32, wobei zusätzlich zu der/den Plasma-Polymer-beschichtungsvorstufe(n) Materialien bei der Plasmaabscheidung vorhanden sind.

36. Verfahren nach Anspruch 35, wobei die Zusatzmaterialien inert sind und als Puffer wirken, ohne dass irgendetwas von ihrer Atomstruktur in das wachsende Plasma-Polymer eingebaut wird.

37. Verfahren nach Anspruch 35, wobei das Zusatzmaterial die Fähigkeit besitzt, das die Beschichtung bildende Material und/oder die sich ergebende durch Plasma abgeschiedene Schicht zu modifizieren und/oder darin eingebaut zu werden.

## Revendications

1. Méthode de fabrication d'une surface chimiquement et/ou physiquement modelée sur un substrat, ladite méthode comprenant l'obtention d'au moins une surface ou d'une sous-couche homogène ayant une fonctionnalité chimique souhaitée et dans laquelle un matériau chimiquement distinct est appliqué pour former une couche supplémentaire ou une couche supérieure qui présente une barrière physique et chimique sur la au moins une sous-couche ou surface et le motif est créé en éliminant sélectivement au moins une partie de ladite couche supplémentaire ou couche supérieure par perforation au moyen d'une pointe d'un dispositif de formation de micro-réseau pour faire apparaître la ou les fonctionnalités chimiques sous-jacentes de la au moins une surface ou sous-couche homogène qui sont spatialement restreintes au motif souhaité par la couche supérieure environnante existante.

2. Méthode selon la revendication 1, dans laquelle la au moins une sous-couche est formée par un moyen comprenant le dépôt d'au moins un matériau pour former la sous-couche et/ou par la modification de la surface du substrat.

3. Méthode selon la revendication 1, dans laquelle le au moins un matériau de sous-couche est utilisé dans les zones où ce dernier a été exposé à l'environnement externe.

4. Méthode selon la revendication 1, dans laquelle une série de revêtements de sous-couche est successivement appliquée sur le substrat avant l'application de la couche supérieure.

5. Méthode selon la revendication 4, dans laquelle l'abrasion de l'empilement multicouche résultant est effectuée à des profondeurs variables sur des zones sélectionnées pour permettre la formation de diverses caractéristiques présentant différentes fonctionnalités, éventuellement de multiples, sur des zones spécifiées de la surface du substrat.

6. Méthode selon la revendication 5, dans laquelle un robot spotteur de micro-réseaux équipé d'une série de pointes de longueurs différentes est utilisé pour retirer sélectivement le matériau à la profondeur requise.

7. Méthode selon la revendication 1, dans laquelle la au moins une sous-couche qui est formée comprend toute une gamme de polymères chimiquement réactifs pouvant encore réagir et être dérivatisés.

8. Méthode selon la revendication 7, dans laquelle les polymères présentent les propriétés suivantes ou l'une quelconque des propriétés suivantes : un caractère hydrophobe, une bioactivité, une capacité de liaison aux protéines, une résistance aux protéines, une capacité d'adhérence aux cellules et/ou une capacité de liaison à l'ADN.

9. Méthode selon la revendication 7, dans laquelle le polymère est un poly(méthacrylate de glycidyle).

10. Méthode selon la revendication 9, dans laquelle on crée une surface de substrat possédant un motif de poly(méthacrylate de glycidyle) exposé sur la surface créant des réseaux spatialement adressés de biomolécules à terminaison amine.

11. Méthode selon la revendication 10, dans laquelle des brins dérivatisés d'ADN et de protéines sont créés dans les zones exposées de la surface du substrat.

12. Méthode selon la revendication 7, dans laquelle les polymères utilisés sont les polymères suivants ou leurs combinaisons : les polymères à fonction aldéhyde pouvant être ensuite dérivatisés avec des biomolécules à fonction amine ; les polymères à fonction thiol pouvant être ensuite dérivatisés avec des fragments à terminaison thiol, les polymères à fonction pyridine qui sont superhydrophiles et qui peuvent être ensuite dérivatisés ou quater-nisés avec des espèces qui comprennent les halogénoalcanes et/ou les polymères à fonction halogène qui peuvent être utilisés comme sites d'initiation pour des procédures de greffage.

13. Méthode selon la revendication 1, dans laquelle la au moins une sous-couche est formée de manière à être de nature non polymère.

14. Méthode selon la revendication 13, dans laquelle les matériaux utilisés pour former la sous-couche comprennent les matériaux suivants ou leurs combinaisons : les métaux, les semiconducteurs, les éléments non métalliques, les céramiques et/ou les surfaces inorganiques telles que le nitrure de silicium et le dioxyde de titane.

15. Méthode selon la revendication 1, dans laquelle un matériau ayant une fonctionnalité qui confère des propriétés très différentes de celles d'un matériau utilisé pour former la couche supérieure est appliqué pour former la au moins une sous-couche.

16. Méthode selon la revendication 15, dans laquelle les propriétés pouvant être prises en considération quand la sous-couche est exposée dans un profil comprennent les propriétés suivantes ou leurs combinaisons : un caractère hydrophobe, un caractère hydrophile, une réactivité chimique spécifique, une capacité de détection chimique, une résistance à l'usure, une barrière contre les gaz, la filtration, un comportement anti-réfléchissant, une libération contrôlée, une résistance au liquide ou au colorant, une meilleure lubrification, une adhérence, une résistance aux protéines, une bio-compatibilité, une bioactivité, une aide à la croissance cellulaire et/ou la capacité à se lier sélectivement à des biomolécules.

17. Méthode selon la revendication 1, dans laquelle la couche supérieure qui est appliquée sur la sous-couche présente une barrière contre toutes les interactions avec la sous-couche recouverte avec l'environnement pendant une échelle de temps spécifiée.

18. Méthode selon la revendication 1, dans laquelle la couche supérieure est suffisamment tendre pour faciliter une élimination au moyen d'une perforation pour faire apparaître la sous-couche fonctionnalisée dans le motif souhaité.

19. Méthode selon la revendication 1, dans laquelle la couche supérieure est de nature polymère.

20. Méthode selon la revendication 19, dans laquelle la couche supérieure est un film polymère mince.

21. Méthode selon la revendication 1, dans laquelle la couche supérieure est appliquée au moyen d'un plasma pulsé.

22. Méthode selon la revendication 21, dans laquelle la couche supérieure est un film mince polymérisé de polystyrène appliqué au moyen d'un plasma pulsé.

23. Méthode selon la revendication 1, dans laquelle la couche supérieure est suffisamment épaisse pour éviter toute interaction importante de la sous-couche recouverte avec l'environnement entourant le substrat.

24. Méthode selon la revendication 1, dans laquelle la au moins une sous-couche comprend un polymère réactif à utiliser, là où il est exposé, pour lier directement des biomolécules et la couche supérieure présente un obstacle chimique et de diffusion à une chimie de liaison de l'ADN en solution.

25. Méthode selon la revendication 1, dans laquelle la au moins une sous-couche est déposée sur le substrat au moyen d'un plasma hors équilibre.

26. Méthode selon la revendication 1, dans laquelle la couche supérieure est un revêtement déposé sur la au moins une sous-couche au moyen d'un plasma hors équilibre.

27. Méthode selon la revendication 1, dans laquelle une pointe de piquage dudit dispositif de formation de micro-réseaux est conçue pour pénétrer dans la couche supérieure afin d'exposer la surface fonctionnelle se trouvant en dessous.

28. Méthode selon la revendication 27, dans laquelle l'étape est accompagnée de la libération simultanée d'une gouttelette de liquide pour permettre en même temps le modelage de la surface et la dérivatisation de la sous-couche exposée.

29. Méthode selon la revendication 1, dans laquelle au moins une sous-couche est retirée en plus de la couche supérieure à au moins un endroit pour former des caractéristiques présentant différentes combinaisons de fonctionnalités exposées sur le même substrat.

30. Méthode selon la revendication 1, dans laquelle l'une ou l'autre ou les deux couches parmi la couche supérieure et/ou la sous-couche sont des polymères de plasma.

31. Méthode selon la revendication 30, dans laquelle le plasma utilisé pour appliquer les polymères de plasma est pulsé.

32. Méthode selon la revendication 31, dans laquelle une décharge lumineuse est produite par l'application d'une tension à haute fréquence, les champs appliqués possédant une puissance moyenne allant jusqu'à 50 W.

33. Méthode selon la revendication 31, dans laquelle la séquence d'impulsions pour le plasma est telle que la puissance est disponible entre 10 µs et 100 µs et indisponible entre 1 000 µs et 20 000 µs.

34. Méthode selon la revendication 32, dans laquelle le substrat sur lequel le ou les revêtements sont appliqués est situé essentiellement à l'intérieur du plasma pulsé lors du dépôt du revêtement.

35. Méthode selon la revendication 32, dans laquelle des matériaux en plus du ou des précurseurs de revêtements polymères de plasma sont présents au niveau du dépôt du plasma.

36. Méthode selon la revendication 35, dans laquelle lesdits matériaux supplémentaires sont inertes et jouent le rôle de tampons sans que leur structure atomique soit incorporée dans le polymère de plasma en formation.

37. Méthode selon la revendication 35, dans laquelle le matériau supplémentaire possède la capacité de modifier et/ou d'être incorporé dans le matériau formant le revêtement et/ou le revêtement résultant déposé par le plasma.
